(19) Europäisches Patentamt
European Patent Office
Office européen des brevets

(11) **EP 1 095 398 B1**

(12) **EUROPÄISCHE PATENTSCHRIFT**

(45) Veröffentlichungstag und Bekanntmachung des Hinweises auf die Patenterteilung:
**07.03.2007 Patentblatt 2007/10**

(21) Anmeldenummer: **99934498.9**

(22) Anmeldetag: **12.05.1999**

(51) Int Cl.:
**H01L 21/8242** *(2006.01)*     **H01L 27/108** *(2006.01)*

(86) Internationale Anmeldenummer:
**PCT/DE1999/001454**

(87) Internationale Veröffentlichungsnummer:
**WO 1999/065063 (16.12.1999 Gazette 1999/50)**

(54) **SPEICHERKONDENSATOR FÜR DRAM**

DRAM STORAGE CAPACITOR

CONDENSATEUR DE MEMORISATION POUR MEMOIRE VIVE DYNAMIQUE (DRAM)

(84) Benannte Vertragsstaaten:
**DE FR GB IE IT**

(30) Priorität: **10.06.1998 DE 19826025**

(43) Veröffentlichungstag der Anmeldung:
**02.05.2001 Patentblatt 2001/18**

(73) Patentinhaber: **Infineon Technologies AG**
**81669 München (DE)**

(72) Erfinder:
  • **REISINGER, Hans**
    **D-82031 Grünwald (DE)**
  • **LEHMANN, Volker**
    **D-80689 München (DE)**
  • **STENGL, Reinhard**
    **D-86391 Stadtbergen (DE)**
  • **WENDT, Hermann**
    **D-85630 Grasbrunn (DE)**
  • **LANGE, Gerrit**
    **D-81373 München (DE)**
  • **BACHHOFER, Harald**
    **D-81677 München (DE)**
  • **FRANOSCH, Martin**
    **D-81739 München (DE)**
  • **SCHÄFER, Herbert**
    **D-85635 Höhenkirchen-Siegertsbrunn (DE)**

(74) Vertreter: **Kottmann, Heinz Dieter et al**
**Patentanwälte**
**MÜLLER & HOFFMANN,**
**Innere Wiener Strasse 17**
**81667 München (DE)**

(56) Entgegenhaltungen:
  EP-A- 0 821 415         US-A- 4 907 046
  US-A- 5 438 541         US-A- 5 629 228
  US-A- 5 641 702

  • **PATENT ABSTRACTS OF JAPAN vol. 16, no. 246 (E-1212), 5. Juni 1992 (1992-06-05) & JP 04 051564 A (FUJITSU LTD), 20. Februar 1992 (1992-02-20)**

EP 1 095 398 B1

**Beschreibung**

Die vorliegende Erfindung betrifft einen Speicherkondensator für einen DRAM mit einem aus Siliziumnitrid bestehenden Dielektrikum und mit wenigstens zwei, über das Dielektrikum einander gegenüberliegenden Elektroden.

Beispielsweise ist in dem Patent US 5,629,228 ein Verfahren zur Herstellung eines DRAM-Speicherkondensators mit einem siliziumnitridhaltigen Dielektrikum angegeben. Weiterhin sind zwei einander gegenüberliegende Elektroden vorgesehen, die beispielsweise aus einem Metall wie Wolfram gebildet sein können.

Die Druckschrift EP 0 821 415 A2 betrifft einen Kondensator und ein entsprechendes Herstellungsverfahren. Der Kondensator wird mit einem ferroelektrischen Dielektrikum gebildet, das beispielsweise mit einer Elektrode aus Iridium kontaktiert wird.

Bekanntlich sollte die gespeicherte Ladung Q in jedem Speicherkondensator eines DRAMs wenigstens einen Wert von 25 fC aufweisen. Die Betriebsspannung U des Speicherkondensators, die beispielsweise $\pm$1 V bei einem Gbit-DRAM beträgt, legt dann über die Beziehung Q = C x U die minimale Speicherkapazität C des Kondensators fest.

Außerdem darf der Leckstrom $I_L$ über das Dielektrikum des Speicherkondensators nur so groß sein, daß der Speicherkondensator während seiner Retentionszeit $t_R$, die etwa 1, s bei einem Gbit-DRAM beträgt, nicht mehr als 10 % seiner Ladung Q verliert. Für das vorliegende Beispiel eines Gbit-DRAMs gilt also:

$$I_L < C/(10 \cdot t_R) \hspace{8cm} (1)$$

Ein für einen Speicherkondensator eines DRAMs geeignetes Dielektrikum mit einer Dielektrizitätskonstanten E muß also die folgenden beiden Bedingungen erfüllen:

(a) Bei einer gewünschten Ladungsdichte Q/A auf Kondensatorelektroden mit der Fläche A, was einem elektrischen Feld E entspricht, für das E $\cdot$ ε ~ Q/A gilt, darf der Leckstrom $I_L$ den oben genannten Wert nicht überschreiten; der Wert für E $\cdot$ ε sollte möglichst hoch sein.

(b) Die obige Bedingung (a) führt bei einer Verminderung der Betriebsspannung zu einer Skalierung mit einer konstanten elektrischen Feldstärke. Unter Skalierung wird dabei verstanden, daß mit immer größeren Speichern und abnehmender Betriebsspannung auch die Schichtdicke des Dielektrikums der Speicherkondensatoren geringer wird, so daß letztlich im Dielektrikum die gleiche Feldstärke herrscht. So hat beispielsweise ein 64 M-Speicher eine Schichtdicke des Dielektrikums von 100 Å (10Å = 1nm) bei einer Betriebsspannung von 3,3 V, ein 264 M-Speicher weist eine Schichtdicke des Dielektrikums von 60 Å und eine Betriebsspannung von 1,25 V auf, während schließlich ein 1 G-Speicher eine Schichtdicke des Dielektrikums von 40 Å und eine Betriebsspannung von 0,9 V hat. Die Skalierbarkeit endet aber bei Erreichen einer bestimmten minimalen Dicke, die kleiner sein muß als die Dicke, die durch die gewünschte Ladungsdichte Q/A vorgegeben ist.

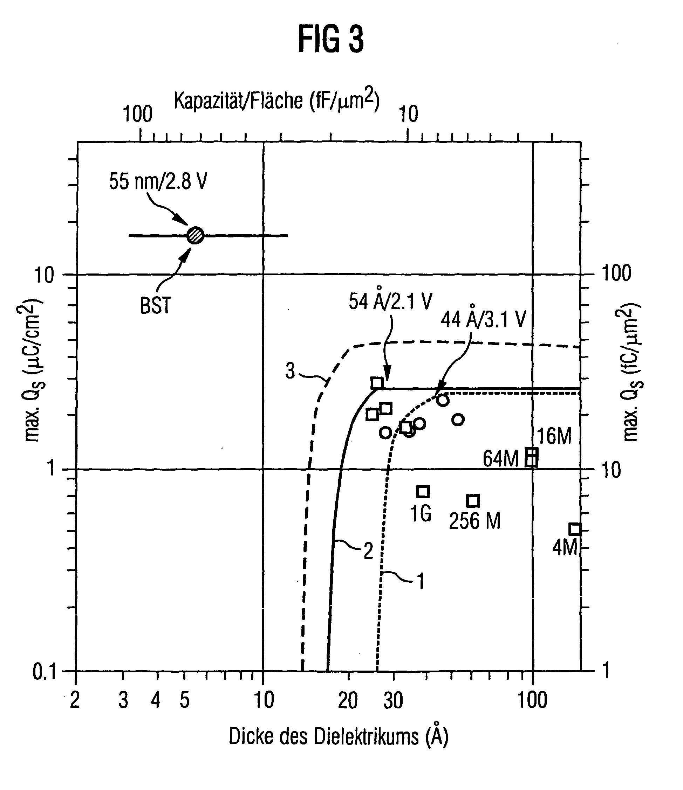

In Fig. 3 sind Ladungsdichten $Q_s$ = Q/A als Funktion der durch ε geteilten Dicke des Dielektrikums in Å aufgetragen, wobei eine Kurve 1 für Siliziumdioxid und eine Kurve 2 für Siliziumnitrid berechnet sind und Punkte o Meßergebnisse für Siliziumnitrid, Punkte □ Meßergebnisse für $Ta_2O_5$ und Punkte ● Meßergebnisse für Bariumstrontiumtitanat (BST) bedeuten. Den jeweiligen Punkten beigefügte Daten geben die Schichtdicke des Dielektrikums, also beispielsweise 55 nm, die anliegende Spannung, also beispielsweise 2,8 V und die entsprechende Speichergeneration, also beispielsweise 1 G, an. Aus der Fig. 3 ist zu ersehen, daß die berechneten Werte und Meßwerte für Siliziumnitrid in erster Näherung übereinstimmen.

Solange die Kurven 1, 2 waagrecht verlaufen, liegt bei konstanter Feldstärke Skalierbarkeit vor. Diese Skalierbarkeit endet aber bei einer Dicke von ca. 30 Å, so daß es jedenfalls nicht möglich erscheint, Siliziumnitrid mit kleineren Schichtdicken erfolgreich als Dielektrikum bei Speicherkondensatoren einsetzen zu können.

Das Ende der Skalierbarkeit ist durch die Zunahme des Stromes durch direktes Tunneln durch das Dielektrikum bedingt. Dieses Tunneln verursacht den drastischen Abfall der Kurven 1, 2 aus ihrem waagrechten Verlauf in deren senkrechten Verlauf.

Aus Fig. 3 ist ohne weiteres entnehmbar, daß im Hinblick auf eine maximale Ladungsdichte $Q_s$ Tantaloxid $Ta_2O_5$ und Siliziumnitrid $Si_3N_4$ etwa gleichwertig sind, während Tantaloxid eine gegenüber Siliziumnitrid etwas bessere Skalierbarkeit zeigt. Wesentlich besser hinsichtlich der maximalen Ladungsdichte $Q_s$ ist BST, das zudem fast beliebig skalierbar ist.

Notwendig für einen erfolgreichen Einsatz in DRAMs als Speicherkondensator-Dielektrikum ist auch eine ausreichend nied-rige Defektdichte des Dielektrikums. Es kann gezeigt werden, dass eine solch niedrige Defektdichte mit Siliziumnitrid, noch nicht jedoch mit Tantaloxid und BST zu erreichen ist. Auch ist zu bedenken, daß BST bisher primär in Keramikkondensatoren eingesetzt wird und mit diesem Material für großinte-grierte Schaltkreise wenig Erfahrung besteht.

Aus allen diesen Gründen und insbesondere infolge der niedri-gen Defektdichte und der guten Integrierbarkeit in bestehen-den DRAM-Prozessen wird Siliziumnitrid als Dielektrikum er-ster Wahl selbst für zukünftige DRAM-Generationen angesehen.

Aus den oben aufgezeigten Gründen haben derzeit Stapel-DRAM-Kondensatoren ein Dielektrikum aus Silizi-umnitrid und weisen üblicherweise Elektroden auf, die aus n$^+$-leitenden polykri-stallinem Silizium hergestellt sind.

Es ist nun Aufgabe der vorliegenden Erfindung, bei einem DRAM-Kondensator mit einem Dielektrikum aus Siliziumnitrid dessen Skalierbarkeit zu verbessern.

Diese Aufgabe wird bei einem Speicherkondensator der eingangs genannten Art erfindungsgemäß dadurch gelöst, daß die Elektroden aus Iridium oder aus Iridiumsiliziden bestehen. Diese Materialien weisen eine hohe Tunnelbarriere zwischen Fermi-Niveau des Materials und Leitungsband des Dielektrikums auf. Mit solchen Elektroden kann die Skalierbarkeit und, damit die Schichtdicke des Dielektrikums weiter auf etwa 25 Å (10Å = 1nm) abgesenkt werden. Bei einem Material aus einem Halbleiter liegt dessen Fermi-Niveau in der Nähe des Randes von dessen Valenzband.

Der erfindungsgemäße Speicherkondensator für DRAMs beruht auf der folgenden Überlegung:

Bestehende Stapel-DRAM-Kondensatoren haben ein Dielektrikum aus Siliziumnitrid und Elektroden aus n$^+$-leitendem polykri-stallinem Silizium, wie dies bereits erläutert wurde. Der Leckstrom und die Skalierbarkeit werden bestimmt durch Tun-neln bzw. direktes Tunneln von Elektronen in bzw. durch das Dielektrikum aus Siliziumnitrid. Dieses Tunneln wiederum hängt von der Tunnelbarriere für Elektronen zwischen Silizi-umnitrid und n$^+$-leitendem polykristallinem Silizium ab.

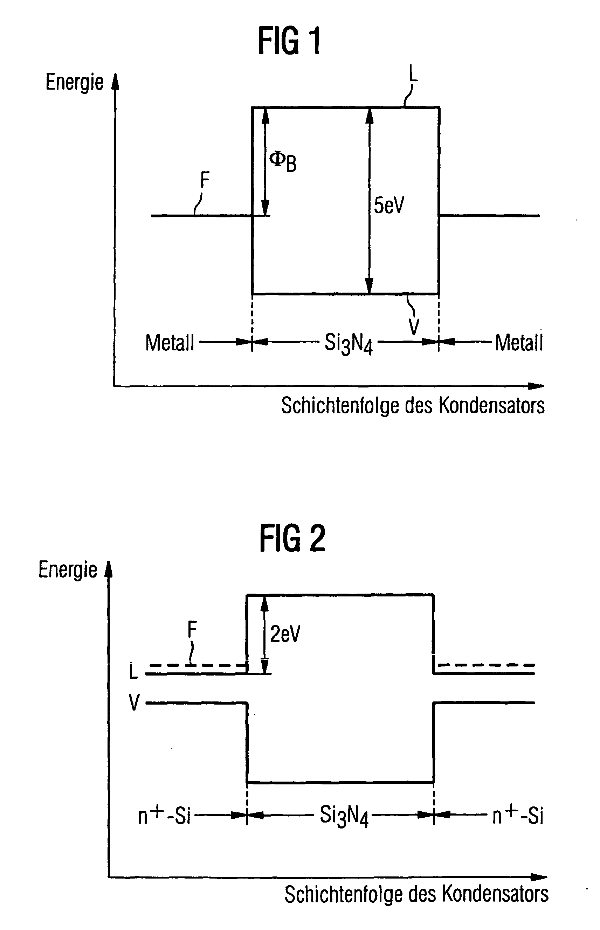

Fig. 2 zeigt den Verlauf von Leitungsband L und Valenzband V in n$^+$-leitendem polykristallinem Silizium (n$^+$-Si) und in dem Dielektrikum aus Siliziumnitrid (Si$_3$N$_4$). Wie aus dieser Fig. 2 zu ersehen ist, besteht eine Energiedifferenz von etwa 2 eV zwischen dem Fermi-Niveau F und dem unteren Rand des Leitungsbandes des Siliziumnitrids.

Eine Erhöhung dieser Barriere von 2 eV senkt nun sowohl den Tunnelstrom als auch die Skalierungsgrenze. Eine Erhöhung der Tunnelbarriere läßt sich aber auf relativ einfache Weise er-reichen, indem Elektroden mit einer höheren Austrittsarbeit als n$^+$-leitendes polykristallines Silizium verwendet werden, also beispielsweise Elektroden aus Iridium oder aus Iridiumsiliziden.

Nachfolgend wird die Erfindung anhand der Figuren näher erläutert. Es zeigen:

Fig. 1    Leitungsband und Valenzband für einen erfindungsgemäßen Speicherkondensator,

Fig. 2    Leitungsband und Valenzband für einen bestehenden Speicherkondensator und

Fig. 3    ein Diagramm zur Erläuterung von mit der Erfindung zu erzielenden Vorteilen.

Fig. 1 zeigt schematisch den Verlauf von Leitungsband und Valenzband bei dem erfindungsgemäßen Speicherkondensator mit einem aus Siliziumnitrid bestehenden Dielektrikum und Elektroden aus Iridium oder Iridiumsilizid. Bei diesem Material liegt das Fermi-Niveau F in der Nähe des Valenzbandes V, so dass eine höhere Tunnelbarriere $\phi_B$ von etwa 3,2 eV bei Iridium gegenüber nur 2 eV in n$^+$-leitendem polykristallinem Silizium vorliegt. Durch diese höhere Tunnelbarriere $\phi_B$ für Elektronen ist der Tunnelstrom vermindert, was wiederum die Skalierungsgrenze ansteigen läßt: mit dem erfindungsgemäßen Speicherkondensator läßt sich die Schichtdicke auf etwa 25 Å vermindern, was durch eine Kurve 3 in Fig. 3 angedeutet ist. Die maximale Ladungsdichte Q$_s$ ist bei dem erfindungsgemäßen Speicherkondensator ebenfalls um etwa einen Faktor 2 höher als bei dem bestehenden Speicherkondensator mit Elektroden 20 aus n$^+$-leitendem polykristallinem Silizium, was ebenfalls durch einen Vergleich zwischen den Kurven 2 und 3 aus der Fig. 3 folgt.

Durch die Erfindung läßt sich also mit relativ einfachen Maßnahmen, nämlich der Verwendung von einem Elektrodenmaterial mit hoher Austrittsarbeit, eine nicht unwesentliche Verbesserung der Skalierbarkeit und der Ladungsdichte erreichen.

Bezugszeichenliste

1    Rechnerischer Wert von Q$_s$ für Siliziumdioxid als Dielektrikum
2    Rechnerischer Wert für Siliziumnitrid als Dielektrikum bei n$^+$-Polysilizium-Elektroden
3    Rechnerischer Wert für Siliziumnitrid als Dielektrikum bei p$^+$-Polysilizium-Elektroden
L    Leitungsband
V    Valenzband
F    Fermi-Niveau

$Q_s$    Ladungsdichte
BST    Bariumstrontiumtitanat
$\phi_B$    Tunnelbarriere

**Patentansprüche**

1.  Speicherkondensator für DRAM, mit einem aus Siliziumnitrid bestehenden Dielektrikum und mit wenigstens zwei, über das Dielektrikum einander gegenüberliegenden Elektroden,
    **dadurch gekennzeichnet,**
    **dass** die Elektroden aus Iridium oder aus Iridiumsiliziden bestehen.

2.  Speicherkondensator nach Anspruch 1,
    **dadurch gekennzeichnet,**
    **dass** die Schichtdicke des Dielektrikums etwa 25 Å, 2.5 nm beträgt.


**Claims**

1.  Storage capacitor for DRAM, having a dielectric composed of silicon nitride and having at least two electrodes located opposite one another through the dielectric,
    **characterized in that** the electrodes are composed of iridium or of iridium silicides.

2.  Storage capacitor according to Claim 1,
    **characterized in that** the layer thickness of the dielectric is approximately 25Å, 2.5 nm.


**Revendications**

1.  Condensateur de mémorisation pour une DRAM, comprenant un diélectrique en nitrure de silicium et au moins deux électrodes opposées l'une à l'autre par le diélectrique,
    **caractérisé**
    **en ce que** les électrodes sont en iridium ou en siliciure d'iridium.

2.  Condensateur de mémorisation suivant la revendication 1,
    **caractérisé**
    **en ce que** l'épaisseur de couche du diélectrique est d'environ 25 Å, 2,5 nm.

## FIG 1

Energie

$\Phi_B$

5eV

F

L

V

Metall ——— Si$_3$N$_4$ ——— Metall

Schichtenfolge des Kondensators

## FIG 2

Energie

2eV

F

L

V

n$^+$-Si ——— Si$_3$N$_4$ ——— n$^+$-Si

Schichtenfolge des Kondensators

# FIG 3